# EUROPÄISCHE PATENTSCHRIFT

(11) **EP 2 342 765 B1**
(45) Veröffentlichungstag und Bekanntmachung des Hinweises auf die Patenterteilung: **23.03.2016**
(21) Anmeldenummer: 09756407.4
(22) Anmeldetag: 16.10.2009
(51) Int. Cl.: H01L 33/38

(54) **LUMINESZENZDIODENCHIP**
LUMINESCENT DIODE CHIP
PUCE DE DIODE ÉLECTROLUMINESCENTE

(30) Priorität: 31.10.2008 DE 102008054218
(43) Veröffentlichungstag der Anmeldung: 13.07.2011
(73) Patentinhaber: OSRAM Opto Semiconductors GmbH, 93055 Regensburg (DE)
(72) Erfinder: BRICK, Peter, 93051 Regensburg (DE); LUCKNER, Hagen, 93080 Pentling (DE); SABATHIL, Matthias, 93059 Regensburg (DE)
(74) Vertreter: Epping - Hermann - Fischer
(86) Internationale Anmeldenummer: PCT/DE2009/001436
(87) Internationale Veröffentlichungsnummer: WO 2010/048921

(56) Entgegenhaltungen:
- DE-A1- 10 049 573
- JP-A- 61 263 289
- US-A- 3 889 286
- US-A- 4 232 440
- US-A1- 2002 063 256
- US-A1- 2003 062 821
- US-A1- 2003 111 667
- US-A1- 2004 105 275
- US-A1- 2008 099 772
- US-A1- 2008 246 047

## Beschreibung

Die vorliegende Anmeldung betrifft einen Lumineszenzdiodenchip.

Der Lumineszenzdiodenchip umfasst eine Halbleiterschichtenfolge, die eine zur Erzeugung von elektromagnetischer Strahlung geeignete aktive Schicht aufweist, und eine erste elektrische Anschlussschicht, die die Halbleiterschichtenfolge berührt und elektrisch leitend kontaktiert. Die erste elektrische Anschlussschicht berührt und kontaktiert die Halbleiterschichtenfolge insbesondere mit einer Mehrzahl von Kontaktflächen.

Es sind Hochleistungs-Lumineszenzdiodenchips bekannt, die, verglichen mit anderen bekannten Lumineszenzdiodenchips, mit einer besonders hohen elektrischen Stromdichte betrieben werden und eine besonders hohe Strahlungsleistung emittieren. Weiterhin sind beispielsweise Scheinwerfer bekannt, die als Leuchtmittel Lumineszenzdiodenchips aufweisen. Ein Beispiel für derartige Scheinwerfer sind Frontscheinwerfer für Kraftfahrzeuge.

Bei Hochleistungs-Lumineszenzdiodenchips ist es ein grundsätzliches Bestreben, dass elektrischer Strom bei Betrieb von diesen möglichst gleichmäßig über die gesamte Halbleiterschichtenfolge verteilt in die Halbleiterschichtenfolge injiziert wird. Um die Lumineszenzdiodenchips möglichst effizient zu gestalten, sollen sie mit einer insgesamt möglichst hohen Stromdichte betrieben werden. Andererseits sollen zu hohe lokale elektrische Stromdichten vermieden werden, da sich diese negativ auf die Funktionalität der Halbleiterschichtenfolge des Lumineszenzdiodenchips auswirken könnten. Mit einer homogen über die gesamte aktive Zone der Halbleiterschichtenfolge verteilten elektrischen Stromdichte kann die gesamte aktive Zone optimal ausgenutzt und der Lumineszenzdiodenchip möglichst effektiv gestaltet werden. Aus der Druckschrift US 2003/0111667 ist bekannt, dass die Stromverteilung im Licht emittierenden Bereich in den Bereichen größer sein soll, die nicht unterhalb des oberen Kontakts liegen, um so den Anteil der Strahlung zu verringern, der von dem oberen Kontakt reflektiert oder absorbiert wird.

Es ist eine Aufgabe, einen Lumineszenzdiodenchip anzugeben, mit dem auf technisch einfache Weise verschiedene Scheinwerferapplikationen, insbesondere ein Frontscheinwerfer für Kraftfahrzeuge realisiert werden können.

Es wird ein Lumineszenzdiodenchip gemäß Anspruch 1 angegeben, dessen erste elektrische Anschlussschicht die Halbleiterschichtenfolge mit einer Mehrzahl von Kontaktflächen berührt und elektrisch leitend kontaktiert. Bei dem Lumineszenzdiodenchip ist gezielt eine inhomogene Stromdichteverteilung oder Stromverteilung in der Halbleiterschichtenfolge durch eine inhomogene Verteilung einer Flächendichte der Kontaktflächen entlang einer Haupterstreckungsebene der Halbleiterschichtenfolge eingestellt.

Anders als bei herkömmlichen Lumineszenzdiodenchips wird also nicht auf eine möglichst homogene Stromverteilung oder Stromdichteverteilung optimiert, sondern es ist gezielt eine inhomogene Stromverteilung eingestellt. Dies bietet beispielsweise die Möglichkeit, eine Abstrahlcharakteristik des Lumineszenzdiodenchips, beispielsweise die Strahlungsdichteverteilung innerhalb eines emittierten Strahlenkegels, noch besser im Hinblick auf spezielle Applikationen zu optimieren.

Die inhomogene Stromdichteverteilung oder Stromverteilung ist gemäß einer vorteilhaften Ausführungsform insbesondere derart eingestellt, dass ein erster Bereich einer Hauptauskoppelfläche der Halbleiterschichtenfolge oder des Lumineszenzdiodenchips eine mindestens drei mal so hohe spezifische Bestrahlungsstärke (Einheit: W/m²) oder spezifische Beleuchtungsstärke (Einheit: lm/m²) aufweist wie mindestens ein zweiter Bereich der Hauptauskoppelfläche der Halbleiterschichtenfolge oder des Lumineszenzdiodenchips.

Die Beleuchtungsstärke der Hauptauskoppelfläche kann z.B. mittels eines Detektors gemessen werden, mit dem man über die Hauptauskoppelfläche fährt und somit eine zweidimensionale rümliche Auflösung der Beleuchtungsstärke erhält. Zusätzlich oder alternativ kann die Beleuchtungsstärke mittels einer Leuchtdichtekamera oder Strahldichtekamera ermittelt werden, indem die Leuchtdichte oder Strahldichte unter verschiedenen Winkeln gemessen und zu der Beleuchtungsstärke oder Bestrahlungsstärke aufintegriert wird.

Die Messung kann in unmittelbarer Nähe zur Hauptauskoppelfläche erfolgen. Alternativ kann auch eine Abbildung der Chipauskoppelfläche, auch in einem größeren Abstand zu der Chipauskoppelfläche, vermessen und somit die Bestrahlungsstärke oder Beleuchtungsstärke der Hauptauskoppelfläche ermittelt werden.

Gemäß einer Ausführungsform des Lumineszenzdiodenchips ist die Bestrahlungsstärke oder Beleuchtungsstärke des ersten Bereichs der Hauptauskoppelfläche mindestens fünf mal oder mindestens zehn mal so groß wie in dem zweiten Bereich.

Die Hauptauskoppelfläche ist die Fläche einer in Hauptabstrahlrichtung des Lumineszenzdiodenchips gewandten Hauptseite, über die eine Auskopplung von elektromagnetischer Strahlung an ein angrenzendes Medium möglich ist. Die Hauptauskoppelfläche ist der aktiven Schicht in Hauptabstrahlrichtung nachgeordnet. Teilflächen, die von einer strahlungsundurchlässigen oder zu mehr als 50% strahlungsabsorbierenden Schicht bedeckt sind, zählen nicht zur Hauptauskoppelfläche. Ein Beipiel für eine solche Schicht sind Bondpads, die auf der Hauptabstrahlseite der Halbleiterschichtenfolge angeordnet sind. Der von einem derartigen Bondpad bedeckte Bereich einer in Hauptabstrahlrichtung gewandten Fläche der Halbleiterschichtenfolge oder des Lumineszenzdiodenchips zählt nicht zur Hauptauskoppelfläche.

Die Hauptauskoppelfläche der Halbleiterschichtenfolge ist entsprechend die der aktiven Schicht in Hauptabstrahlrichtung nachgeordnete Fläche einer in Hauptabstrahlrichtung gewandten Hauptseite der Halbleiterschichtenfolge selbst. Sie kann insbesondere durch die Außenfläche einer Halbleiterschicht gebildet sein oder diese aufweisen. Die Hauptauskoppelfläche des Lumineszenzdiodenchips kann dagegen zumindest teilweise durch ein Material gebildet sein, das nicht Bestandteil der Halbleiterschichtenfolge ist.

In einer Ausführungsform des Lumineszenzdiodenchip ist auf die Hauptauskoppelfläche der Halbleiterschichtenfolge ein Lumineszenzkonversionsmaterial aufgebracht. Das Lumineszenzkonversionsmaterial weist mindestens einen Leuchtstoff auf, der durch die von der aktiven Schicht emittierte elektromagnetische Strahlung anregbar ist und diese in eine elektromagnetische Strahlung mit verändertem Emissionsspektrum konvertiert. Wenn die Hauptauskoppelfläche der Halbleiterschichtenfolge mit einem derartigen Lumineszenzkonversionsmaterial bedeckt ist und der Lumineszenzdiodenchip kein weiteres Material aufweist, das dem Lumineszenzkonversionsmaterial in Hauptabstrahlrichtung nachgeordnet ist, dann ist die Hauptauskoppelfläche des Lumineszenzdiodenchips zumindest teilweise durch die in Hauptabstrahlrichtung gewandte Fläche des Lumineszenzkonversionsmaterials gebildet.

Die Hauptauskoppelfläche des Lumineszenzdiodenchip kann grundsätzlich zumindest teilweise durch beliebiges, strahlungsdurchlässiges Material, das kein Material der Halbleiterschichtenfolge ist, gebildet sein.

In der Beschreibung sowie in den Patentansprüchen ist unter einer Hauptauskoppelfläche die Hauptauskoppelfläche der Halbleiterschichtenfolge, die Hauptauskoppelfläche des Lumineszenzdiodenchips oder die Hauptauskoppelfläche sowohl der Halbleiterschichtenfolge als auch des Lumineszenzdiodenchips zu verstehen.

Die Kontaktflächen sind vorzugsweise voneinander beabstandet. Alternativ ist es jedoch auch möglich, dass die Mehrzahl von Kontaktflächen oder einige der Kontaktflächen einstückig miteinander ausgebildet sind. Beispielsweise können mehrere, relativ große Kontaktflächen mittels relativ dünner Kontaktstege, die die Halbleiterschichtenfolge ebenfalls berühren, miteinander verbunden sein. Verglichen mit den relativ großen Kontaktflächen wird über die Kontaktstege jedoch vorzugsweise deutlich weniger elektrischer Strom in die Halbleiterschichtenfolge injiziert. Beispielsweise wird über etwaige Kontaktstege oder Kontaktverbindungen weniger als 10%, bevorzugt weniger als 5%, besonders bevorzugt weniger als 2% des Gesamtstroms in die Halbleiterschichtenfolge injiziert.

Bei einer Ausgestaltung des Lumineszenzdiodenchips weist die erste Anschlussschicht mindestens 10, bevorzugt mindestens 25, besonders bevorzugt mindestens 50 Kontaktflächen auf. Wie bereits erwähnt sind die Kontaktflächen zumindest zum Großteil jeweils voneinander beabstandet. Sie können jedoch auch teilweise oder vollständig miteinander verbunden ausgeführt sein. Beispielsweise können mehrere, relativ großflächige Kontaktflächen mittels relativ kleinflächiger Verbindungselemente, beispielsweise Verbindungsstege, verbunden sein. Entscheidend ist, dass eine ausreichend inhomogene Stromdichteverteilung mittels einer inhomogenen Verteilung der Flächendichte der Kontaktflächen in der Halbleiterschichenfolge realisiert ist.

Gemäß einer Ausgestaltung ist die inhomogene Stromverteilung auch eine unsymmetrische Stromverteilung in der Halbleiterschichtenfolge. Diese ist gezielt durch eine unsymmetrische Verteilung der Flächendichte der Kontaktflächen entlang einer Haupterstreckungsebene der Halbleiteschichtenfolge eingestellt. Mit den angegebenen technischen Mitteln sind gerade auch unsymmetrische Stromverteilungen in der Halbleiterschichtenfolge auf technisch einfache Weise gezielt realisierbar.

Bei einer weiteren Ausführungsform des Lumineszenzdiodenchips weist die Hauptauskoppelfläche der Halbleiterschichtenfolge oder des Lumineszenzdiodenchips in Draufsicht eine lang gestreckte Form auf. Unter einer Draufsicht ist eine Sicht auf die Hauptauskoppelfläche unter einem Winkel zu verstehen, der senkrecht zu einer Haupterstreckungsebene der Hauptauskoppelfläche oder der Halbleiterschichtenfolge verläuft.

Die lang gestreckte Form weist eine Länge auf, worunter eine Erstreckung der Hauptauskoppelfläche entlang einer Haupterstreckungsrichtung von dieser zu verstehen ist. Gemäß einer Weiterbildung des Lumineszenzdiodenchips beträgt die Länge zwischen einschließlich 2 mm und einschließlich 10 mm. Bevorzugt beträgt die Länge mehr als oder gleich 3 mm, besonders bevorzugt mehr als oder gleich 4 mm. Durch die Verwendung einer Mehrzahl von über die Halbleiterschichtenfolge verteilter Kontaktflächen ist der Lumineszenzdiodenchip gut in seiner Größe skalierbar.

Die lang gestreckte Hauptauskoppelfläche weist eine Breite auf, worunter eine senkrecht zur Länge gemessene Erstreckung der Hauptauskoppelfläche in Draufsicht auf diese zu verstehen ist. Die Breite beträgt gemäß einer Ausgestaltung mehr als oder gleich 0,5 mm und weniger als oder gleich 2 mm. Bevorzugt beträgt die Breite mindestens 1 mm.

Das Verhältnis von Länge zu Breite der Hauptauskoppelfläche beträgt mehr als oder gleich 4:1, bevorzugt mehr als oder gleich 5:1 oder 6:1.

Zur Beschreibung einer weiteren Ausführungsform des Lumineszenzdiodenchips wird die Hauptauskoppelfläche mit einer gedachten Unterteilung in zwei Hälften geteilt. Die zwei Hälften sind mit einer Grenzgeraden voneinander getrennt, die eine Längenstrecke der Hauptauskoppelfläche senkrecht in der Mitte schneidet. Die Längenstrecke entspricht der oben definierten Länge der lang gestreckten Hauptauskoppelfläche. Bei der Ausführungsform ist vorgesehen, dass die summierte Fläche oder die Anzahl der Kontaktflächen in Draufsicht im Bereich von einer der Hälften um mindestens 15%, bevorzugt um mindestens 20% größer ist als im Bereich der anderen Hälfte.

Eine weitere Ausführungsform des Lumineszenzdiodenchips wird mit Hilfe einer gedachten Unterteilung der lang gestreckten Hauptauskoppelfläche in drei Drittel definiert. Diese Unterteilung weist Grenzgeraden auf, die die Längenstrecke der Hauptauskoppelfläche senkrecht schneiden. Eine erste Grenzgerade schneidet die Längenstrecke bei einem Drittel und eine zweite Grenzgerade schneidet die Längenstrecke bei zwei Drittel ihrer Gesamtlänge. Die Ausführungsform sieht vor, dass die summierte Fläche oder die Anzahl der Kontaktflächen in Draufsicht im Bereich des mittleren Drittels um mindestens 30%, bevorzugt mindestens 45%, besonders bevorzugt um mindestens 65% größer ist als jeweils in den Bereichen der äußeren beiden Drittel.

Gemäß einer weiteren Ausführungsform des Lumineszenzdiodenchips weist die Hauptauskoppelfläche in Draufsicht eine unsymmetrische Form auf.

Die Hauptauskoppelfläche der Halbleiterschichtenfolge oder des Lumineszenzdiodenchips weist gemäß einer weiteren Ausgestaltung des Lumineszenzdiodenchips in Draufsicht zwei Abschnitte eines Randes auf, die an der Außenseite der Hauptauskoppelfläche einen Winkel zwischen einschließlich 155° und einschließlich 175° einschließen.

Bei einer Weiterbildung dieser Ausgestaltung ist vorgesehen, dass der erste Bereich der Hauptauskoppelfläche an einen der zwei Abschnitte des Randes angrenzt oder einen Abstand zu einem der zwei Abschnitte aufweist, der höchstens 20% der maximalen Breite der Hauptauskoppelfläche beträgt.

Bezogen auf die Stromdichte und die entsprechende Strahlendichte ist in der Nähe von zumindest einem der zwei Abschnitte des Randes ein Hot Spot der Hauptauskoppelfläche vorhanden. Der Hot Spot grenzt entweder unmittelbar an mindestens einen der zwei Abschnitte an. Alternativ weist der Hot Spot einen Abstand zu mindestens einem der zwei Abschnitte des Randes auf, der höchstens 20% der maximalen Breite der hauptauskoppelfläche beträgt. Beispielsweise beträgt der Abstand 30µm, 50µm, 100µm oder 200µm.

Bei einer Ausführungsform, bei der die Hauptauskoppelfläche eine lang gestreckte Form aufweist, ist gemäß einer Ausgestaltung vorgesehen, dass die Breite der Hauptauskoppelfläche an einer Stelle oder in einem Bereich ein zumindest lokales Minimum aufweist, so dass der Stelle oder dem Bereich in beiden Richtungen entlang der Länge der Hauptauskoppelfläche Abschnitte mit zunehmend größer werdender Breite folgen. Das Minimum an der Stelle oder in dem Bereich kann insbesondere auch ein globales Minimum der Breite der Hauptauskoppelfläche sein.

Gemäß mindestens einer weiteren Ausführungsform ist die erste Anschlussschicht auf einer der Hauptauskoppelflächen abgewandten Rückseite der Halbleiterschichtenfolge angeordnet. Bei einer Ausgestaltung dieser Ausführungsform ist vorgesehen, dass eine zweite elektrische Anschlussschicht vorhanden ist, die ebenfalls auf der Rückseite der Halbleiterschichtenfolge angeordnet ist. Die zweite elektrische Anschlussschicht überlappt lateral mit der ersten elektrischen Anschlussschicht und ist elektrisch gegen diese isoliert.

Das Merkmal, dass die erste oder die zweite elektrische Anschlussschicht auf der Rückseite angeordnet ist, bedeutet, dass zumindest ein Teil dieser Anschlussschicht der Halbleiterschichtenfolge in Richtung von der Hauptauskoppelfläche zur Rückseite hin nachfolgt. Es ist jedoch nicht notwendig, dass die gesamte erste oder zweite elektrische Anschlussschicht an der Rückseite angeordnet ist. Vielmehr kann sich beispielsweise ein Teilbereich der ersten elektrischen Anschlussschicht von der Rückseite durch einen Durchbruch der aktiven Schicht hindurch in Richtung zu der Vorderseite hin erstrecken.

Mit Vorteil ist bei einer weitergehenden Ausgestaltung zusätzlich vorgesehen, dass sich zumindest ein Teilbereich der ersten elektrischen Anschlussschicht von der Rückseite durch einen Durchbruch der aktiven Schicht hindurch in Richtung zu der Hauptauskoppelfläche erstreckt. Es können insbesondere auch mehrere Teilbereiche der ersten elektrischen Anschlussschicht vorhanden sein, die sich insbesondere jeweils durch einen eigenen Durchbruch der aktiven Schicht hindurch in Richtung zur Hauptauskoppelfläche erstrecken können. Der mindestens eine Teilbereich berührt die Halbleiterschichtenfolge und bildet mindestens eine oder alle der Kontaktflächen der ersten elektrischen Anschlussschicht.

Wenn sich ein Teilbereich der ersten elektrischen Anschlussschicht von der Rückseite durch einen Durchbruch der aktiven Schicht hindurch in Richtung zu der Hauptauskoppelfläche hin erstreckt, dann sind die Kontaktflächen der ersten Anschlussschicht bevorzugt jeweils in einem Durchbruch angeordnet.

Bevorzugt ist eine Mehrzahl von Durchbrüchen der aktiven Schicht vorhanden, durch die hindurch sich ein Teilbereich der ersten elektrischen Anschlussschicht von der Rückseite zu der Hauptauskoppelfläche hin erstreckt. Besonders bevorzugt ist jede der Kontaktflächen der ersten elektrischen Anschlussschicht einem eigenen Durchbruch zugeordnet.

Gemäß einer alternativen Ausführungsform ist eine zweite elektrische Anschlussschicht vorhanden und sind die erste und die zweite elektrische Anschlussschicht auf einander gegenüberliegenden Seiten der Halbleiterschichtenfolge angeordnet. Wenn die zweite elektrische Anschlussschicht auf der Seite der Hauptauskoppelfläche angeordnet ist, ist die erste elektrische Anschlussschicht auf der gegenüber liegenden Rückseite der Halbleiterschichtenfolge angeordnet. Wenn die erste elektrische Anschlussschicht auf der Seite der Hauptauskoppelfläche angeordnet ist, ist die zweite elektrische Anschlussschicht auf der gegenüber liegenden Rückseite der Halbleiterschichtenfolge angeordnet.

Bei einer Ausgestaltung des Lumineszenzdiodenchips weist die Hauptauskoppelfläche der Halbleiterschichtenfolge eine Strukturierung auf, die geeignet ist, die Ausbreitung und Auskopplung der in der aktiven Schicht emittierten Strahlung zu beeinflussen. Mit Vorteil weist die Strukturierung eine erste laterale Erstreckung, eine senkrecht zur ersten lateralen Erstreckung gemessene zweite laterale Erstreckung und/oder eine vertikale Erstreckung auf, die größer oder gleich dem 0,2-fachen einer Wellenlänge des Emissionsmaximums der elektromagnetischen Strahlung und kleiner oder gleich dem fünffachen einer Wellenlänge des Emissionsmaximums der elektromagnetischen Strahlung ist. Bevorzugt sind sowohl die erste laterale Erstreckung als auch die zweite laterale Erstreckung und die vertikale Erstreckung von zumindest einem Großteil der Struktureinheiten jeweils größer oder gleich dem 0,2-fachen einer Wellenlänge des Emissionsmaximums der elektromagnetischen Strahlung und kleiner oder gleich dem fünffachen der Wellenlänge des Emissionsmaximums.

Gemäß einer vorteilhaften Ausführungsform emittiert der Lumineszenzdiodenchip bei seinem Betrieb einen Strahlungskegel mit einer Strahldichteverteilung, die einer Strahldichteverteilung für ein Abblendlicht eines Kraftfahrzeuges entspricht. Die Strahldichteverteilung ist insbesondere derart, dass der Strahlungskegel lediglich mittels einer Projektionsoptik in einen gewünschten Raumwinkel projiziert werden muss, dass die Spezifikationen eines Abblendlichts für ein Kraftfahrzeug realisiert werden. Die Projektionsoptik muss dabei die Strahldichteverteilung nicht oder nur in einem geringen Maße beeinflussen, damit die Spezifikationen realisiert sind.

Der Lumineszenzdiodenchip ist gemäß einer Ausgestaltung frei von einem Aufwachssubstrat wie beispielsweise einem Epitaxiesubstrat, auf dem die Halbleiterschichtenfolge bei ihrer Herstellung aufgewachsen worden ist. Ein solches Aufwachsubstrat ist von der Halbleiterschichtenfolge zumindest zu einem Großteil oder vollständig entfernt.

Zusätzlich oder alternativ weist der Lumineszenzdiodenchip an seiner Rückseite ein Trägersubstrat auf. Das Trägersubstrat ist kein Aufwachssubstrat sondern es ist ein Träger, der nach dem Ausbilden der Halbleiterschichtenfolge mit dieser verbunden wird. Die erste elektrische Anschlussschicht und gegebenenfalls auch die zweite elektrische Anschlussschicht können insbesondere zwischen der Halbleiterschichtenfolge und dem Trägersubstrat angeordnet sein.

Die verschiedenen Merkmale und Ausführungsformen hinsichtlich der Form der Hauptauskoppelfläche, insbesondere in Draufsicht betrachtet, sind für sich gesehen bereits eine Erfindung, die auch unabhängig von dem gezielten Einstellen einer inhomogenen Stromdichteverteilung durch eine inhomogene Verteilung der Flächendichte der Kontaktflächen mit Vorteil realisiert werden kann.

Weitere Vorteile, bevorzugte Ausführungsformen und Weiterbildungen des Lumineszenzdiodenchips ergeben sich aus den im folgenden in Verbindung mit den Figuren erläuterten Ausführungsbeispielen. Es zeigen:
- Figur 1: eine schematische Draufsicht auf die Hauptauskoppelfläche des Lumineszenzdiodenchips gemäß eines ersten Ausführungsbeispiels;
- Figur 2: eine schematische Draufsicht auf die Hauptauskoppelfläche des Lumineszenzdiodenchips gemäß eines zweiten Ausführungsbeispiels;
- Figur 3: eine schematische Draufsicht auf die Hauptauskoppelfläche des Lumineszenzdiodenchips gemäß des ersten Ausführungsbeispiels mit eingetragenen Bereichen unterschiedlich großer emittierter Strahlungsintensität;
- Figur 4: eine schematische Seitenansicht einer Anordnung des Lumineszenzdiodenchips mit einer Abbildungsoptik;
- Figur 5: eine Darstellung einer beispielhaften Strahlungsintensitätsverteilung eines von der Abbildungsoptik in Figur 4 emittierten Strahlungskegels im Querschnitt;
- Figur 6: eine schematische Schnittansicht eines Teils des Lumineszenzdiodenchips gemäß eines dritten Ausführungsbeispiels;
- Figur 7: eine schematische Schnittansicht eines Teils der Lumineszenzdiodenchips gemäß eines vierten Ausführungsbeispiels;
- Figur 8: eine schematische Schnittansicht eines teils des Lumineszenzdiodenchips gemäß eines fünften Ausführungsbeispiels;

- Figur 9: eine schematische Draufsicht auf die Hauptauskoppelfläche des Lumineszenzdiodenchips gemäß eines sechsten Ausführungsbeispiels;
- Figur 10: eine schematische Draufsicht auf die Hauptauskoppelfläche des Lumineszenzdiodenchips gemäß eines siebten Ausführungsbeispiels;
- Figur 11: eine schematische Draufsicht auf die Hauptauskoppelfläche des Lumineszenzdiodenchips gemäß eines achten Ausführungsbeispiels;
- Figur 12: eine schematische Draufsicht auf die Hauptauskoppelfläche des Lumineszenzdiodenchips gemäß eines neunten Ausführungsbeispiels; und
- Figur 13: eine schematische Draufsicht auf die Hauptauskoppelfläche des Lumineszenzdiodenchips gemäß eines zehnten Ausführungsbeispiels.

In den Ausführungsbeispielen und Figuren sind gleiche oder gleich wirkende Bestandteile jeweils mit den gleichen Bezugszeichen versehen. Die dargestellten Bestandteile sowie die Größenverhältnisse der Bestandteile untereinander sind nicht als maßstabsgerecht anzusehen. Vielmehr sind einige Details der Figuren zum besseren Verständnis übertrieben groß dargestellt.

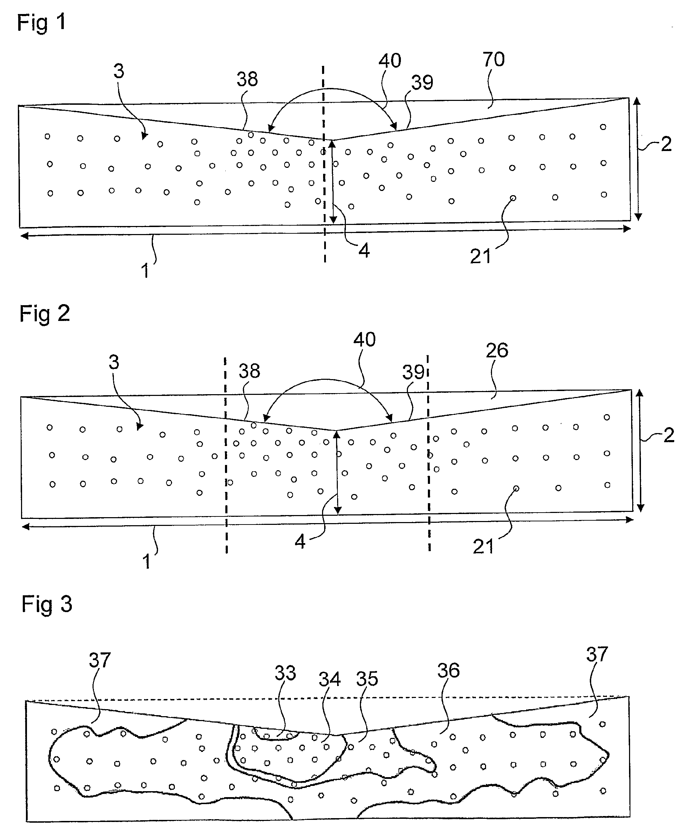

In Figur 1 ist ein Lumineszenzdiodenchip in einer Draufsicht auf eine Hauptauskoppelfläche 3 schematisch dargestellt. Er weist in Draufsicht eine lang gestreckte und unsymmetrische Form auf. Die Form des Lumineszenzdiodenchips ist beispielsweise derart, dass man sie ausgehend von einem Rechteck erhält, in dem man dieses an einer Längsseite mit einer Aussparung 70 versieht. Die Aussparung 70 weist beispielsweise die Form eines Dreieckes oder eine Form in der Art eines Dreieckes auf. "In der Art eines Dreickes" bedeutet, dass die Form der Aussparung nicht zwingend der exakten mathematischen Definition eines Dreickes entsprechen muss, sondern geringfügige Abweichungen von dieser Form möglich sind. Beispiele für solche möglichen geringfügigen Abweichungen sind verrundete Kanten oder nicht exakt gerade verlaufende Seitenlinien.

Bei dem in Figur 1 dargestellten Ausführungsbeispiel ist das Dreieck kein gleichschenkliges Dreieck. Bei einer alternativen Ausführungsform könnte es grundsätzlich jedoch auch ein gleichschenkliges Dreieck sein. In so einem Fall könnte die Form des Lumineszenzdiodenchips in Draufsicht oder die Form der Hauptauskoppelfläche 3 auch eine Spiegelsymmetrie aufweisen.

Bei dem in Figur 2 dargestellten Ausführungsbeispiel weist die Hauptauskoppelfläche 3 des in Draufsicht dargestellten Lumineszenzdiodenchips die selbe Form auf wie bei dem anhand Figur 1 erläuterten Ausführungsbeispiel. Im Unterschied zu dem in Figur 1 veranschaulichten Ausführungsbeispiel weist der in Figur 2 dargestellte Lumineszenzdiodenchip jedoch keine Aussparung 70 auf. Statt dessen ist in Draufsicht an der Stelle, bei der im ersten Ausführungsbeispiel die Aussparung 70 ist, ein Bondpad 26 ausgebildet. Der Lumineszenzdiodenchip weist somit insgesamt in Draufsicht eine andere Form auf als die Hauptauskoppelfläche 3. Beispielsweise weist der Lumineszenzdiodenchip eine rechteckige Form oder eine Form in der Art eines Rechteckes auf.

Das Bondpad 26 ist auf einer in Hauptabstrahlrichtung gewandten Hauptseite des Lumineszenzdiodenchips angeordnet. Es fungiert als eine Blende. Das Bondpad schirmt zumindest einen Großteil der in der aktiven Schicht des Lumineszenzdiodenchips erzeugten Strahlung, die auf das Bondpad 26 trifft, ab. Bevorzugt schirmt es mehr als 70%, mehr als 80% oder mehr als 90% der Strahlung ab, die auf es trifft. Das Bondpad 26 kann insbesondere im wesentlichen vollständig undurchlässig für die in der aktiven Schicht erzeugte elektromagnetische Strahlung sein.

Bezogen auf das in Figur 1 veranschaulichte Ausführungsbeispiel könnte der Lumineszenzdiodenchip statt einer Aussparung 70 beispielsweise auch einen entsprechend der dargestellten Aussparung 70 geformten Teil einer Halbleiterschichtenfolge aufweisen, der entweder keine aktive Schicht aufweist oder dessen aktive Schicht elektrisch von dem übrigen Teil des Lumineszenzdiodenchips getrennt ist. Auch in so einem Fall würde die effektive Hauptauskoppelfläche 3 eine andere Form aufweisen als der Lumineszenzdiodenchip in Draufsicht insgesamt. Eine in Hauptabstrahlrichtung gewandte Fläche, über die geringfügig Strahlung ausgekoppelt wird, die jedoch nicht lateral mit einem Teil der aktiven Schicht überlappt, ist nicht als Teil der Hauptauskoppelfläche anzusehen.

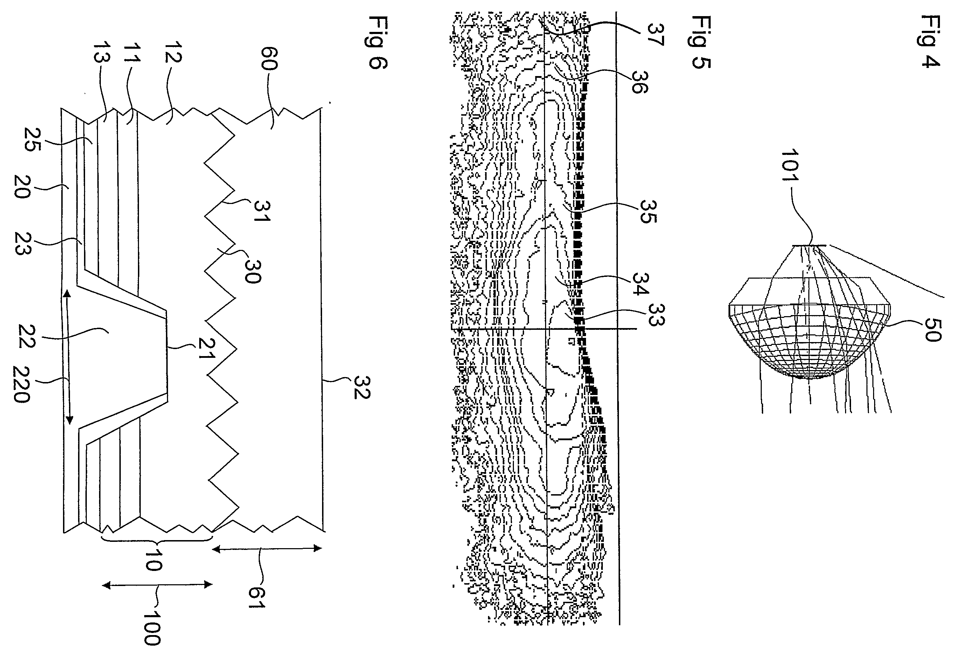

In den Figuren 1 und 2 ist jeweils die Position einer Mehrzahl von Kontaktflächen 21 einer ersten elektrischen Anschlussschicht des Lumineszenzdiodenchips eingezeichnet. Die Kontaktflächen 21 können auf einer in Hauptabstrahlrichtung gewandten Vorderseite einer Halbleiterschichtenfolge des Lumineszenzdiodenchips angeordnet sein. Alternativ können Sie auch auf einer der Hauptabstrahlrichtung abgewandten Rückseite der Halbleiterschichtenfolge des Lumineszenzdiodenchips angeordnet sein. Bei einer weiteren Alternative sind die Kontaktflächen 21 in der Halbleiterschichtenfolge des Lumineszenzdiodenchips angeordnet, das heißt sie befinden sich in vertikaler Richtung zwischen der Vorderseite und der Rückseite der Halbleiterschichtenfolge. Derartige unterschiedliche Ausführungsformen sind im Zusammenhang mit den Figuren 6, 7 und 8 näher erläutert.

Die anhand der Figuren 1 und 2 veranschaulichten Lumineszenzdiodenchips weisen beide beispielsweise 72 Kontaktflächen 21 der ersten elektrischen Anschlussschicht auf. Es könnten auch mehr Kontaktflächen sein, beispielsweise mindestens 75, mindestens 80 oder mindestens 90 Kontaktflächen 21. Alternativ könnten es auch weniger Kontakte sein, beispielsweise zwischen einschließlich 50 und einschließlich 70 Kontaktflächen.

Die Kontaktflächen sind beispielsweise alle gleich groß. Alternativ können die Chips auch unterschiedlich große Kontaktflächen 21 der ersten elektrischen Anschlussschicht aufweisen. Insbesondere kann die Flächendichte der Kontaktflächen 21 entlang der Haupterstreckungsebene der Halbleiterschichtenfolge zumindest teilweise durch unterschiedlich große Kontaktflächen eingestellt sein. Zusätzlich oder alternativ ist die Flächendichte durch eine Variierung der Anzahl der Kontaktflächen entlang der Haupterstreckungsebene der Halbleiterschichtenfolge eingestellt.

Die Kontaktflächen 21 sind in den Ausführungsbeispielen alle voneinander beabstandet. Wie im allgemeinen Teil der Beschreibung bereits erläutert, ist dies jedoch nicht zwingend notwendig. So können beispielsweise größere Kontaktflächen mittels vergleichsweise kleinflächigen Kontaktflächenverbindungsstücken untereinander verbunden sein. In diesem Fall ist jedes größere kompakte Kontaktflächenteil als eine Kontaktfläche 21 anzusehen. Man kann in diesem Fall auch von Kontaktflächeninseln sprechen, die zumindest teilweise mittels Kontaktflächenverbindungsstücken miteinander verbunden sind.

In Figur 1 ist mittels einer gestrichelten Linie eine Grenzgerade eingezeichnet, welche die Hauptauskoppelfläche 3 in zwei Hälften teilt. Die Grenzgerade verläuft senkrecht zu einer Längenstrecke 4 der Hauptauskoppelfläche 3 und schneidet diese senkrecht in der Mitte. Die Längenstrecke 4 erstreckt sich über die gesamte Ausdehnung der Hauptauskoppelfläche 3 oder des Lumineszenzdiodenchips in Richtung ihrer oder seiner Haupterstreckungsgeraden.

Bei den so eingeteilten zwei Hälften hat die in Figur 1 in Draufsicht linke Hälfte beispielsweise 39 gleich große Kontaktflächen. Die rechte Hälfte weist zum Beispiel 32 gleich große Kontaktflächen auf. Die Grenzgerade verläuft durch eine Kontaktfläche 21 hindurch, welche weder der einen noch der anderen Hälfte zugerechnet wird. Somit ist die Anzahl der Kontaktflächen in der linken Hälfte um mehr als 20% größer als in der rechten Hälfte. Wenn die Kontaktflächen alle gleich groß sind, dann ist die summierte Fläche der Kontaktflächen 21 in der linken Hälfte ebenfalls um mehr als 20% größer als in der rechten Hälfte. Allein dadurch ist bereits eine inhomogene Verteilung der Flächendichte der Kontaktflächen entlang einer Haupterstreckungsebene der Halbleiterschichtenfolge eingestellt.

In Figur 2 sind zwei gestrichelte Linien eingetragen, welche Grenzgeraden darstellen, die die Hauptauskoppelfläche 3 in drei Drittel teilen. Die Grenzgeraden schneiden die Längenstrecke 1 jeweils senkrecht. Die eine Grenzgerade schneidet die Längenstrecke 1 bei ein Drittel ihrer Länge und die andere schneidet die Längenstrecke 1 bei zwei Drittel ihrer Länge.

Im mittleren Drittel sind 33 Kontaktflächen 21 enthalten. In dem linken äußeren Drittel sind 19 Kontaktflächen 21 und in dem rechten äußeren Drittel sind 20 Kontaktflächen 21 enthalten. Somit sind in dem mittleren Drittel mehr als 60% mehr Kontaktflächen 21 angeordnet als jeweils in den äußeren beiden Dritteln. Wenn die Kontaktflächen zudem alle gleich groß sind, dann ist damit auch die summierte Größe der Kontaktflächen 21 im mittleren Drittel entsprechend größer als die jeweilige summierte Kontaktfläche der beiden äußeren Drittel.

Es versteht sich, dass die Kontaktflächen 21 nicht oder nicht notwendigerweise auf der Hauptauskoppelfläche 3 angeordnet sind. Vielmehr bezieht sich die Unterteilung und die jeweilige Anzahl und summierte Größe der Kontaktflächen 21 auf die Kontaktflächen 21, die sich bei einer Draufsicht auf die Hauptauskoppelfläche 3 in dem jeweiligen Bereich der Hauptauskoppelfläche 3, insbesondere unterhalb der Hauptauskoppelfläche 3 befinden. Die Kontaktflächen 21 befinden sich also im Bereich der einen oder der anderen Hälfte (Figur 1) oder im Bereich von einem der Drittel der Hauptauskoppelfläche 3 (Figur 2).

Wenn man in Figur 2 das mittlere Drittel der Hauptauskoppelfläche halbiert, dann befinden sich im Bereich von einer dieser zwei Hälften 20 Kontaktflächen 21 und im Bereich der anderen Hälfte 12 Kontaktflächen 21. Somit sind in der einen der Hälften des mittleren Drittels mehr als 60% mehr Kontaktflächen 21 angeordnet als in der anderen Hälfte des mittleren Drittels der Hauptauskoppelfläche 3.

Die Hauptauskoppelfläche 3 weist in Draufsicht eine Stelle auf, an der ihre Breite ein Minimum 4 hat. Der Stelle mit der minimalen Breite 4 folgen in beiden Richtungen entlang der Länge 1 der Hauptauskoppelfläche Abschnitte mit zunehmend größer werdender Breite.

An den Enden oder an einander gegenüberliegenden Rändern weist die Hauptauskoppelfläche 3 z.B. eine maximale Breite 2 auf. Dies ist die Breite der Hauptauskoppelfläche 3, das heißt die maximale Erstreckung senkrecht zu einer Haupterstreckungsgeraden der Hauptauskoppelfläche 3.

Der Rand der Hauptauskoppelfläche 3 weist zwei Abschnitte 38, 39 auf, die an der Außenseite der Hauptauskoppelfläche 3 einen Winkel 40 von beispielsweise etwa 165° bilden. Anders ausgedrückt sind die beiden Abschnitte 38, 39 um etwa 15° zueinander verkippt.

Ein Lumineszenzdiodenchip mit einer derart geformten Hauptauskoppelfläche 3 eignet sich besonders als Leuchtmittel für einen Scheinwerfer eines Kraftfahrzeugs. Für ein Abblendlicht eines derartigen Scheinwerfers sieht die Norm unter anderem eine scharfe Hell-Dunkel-Grenze im oberen Bereich eines emittierten Scheinwerferkegels vor. Diese Hell-Dunkel-Grenze soll in einem ersten Abschnitt in etwa horizontal zu einer Straße verlaufen und in einem zweiten Abschnitt unter etwa 15° gegenüber der Horizontalen zum Straßenrand hin nach oben verlaufen.

Die beiden Abschnitte 38, 39 des Randes der Hauptauskoppelfläche 3 sind beispielsweise jeweils gerade ausgeführt. Dies ist jedoch nicht zwingend erforderlich. Beispielsweise kann mindestens einer der Abschnitte zumindest abschnittsweise leicht gekrümmt oder mit einem beliebigen anderen Verlauf, der von einer Geraden abweicht, ausgebildet sein. In einem solchen Fall wird der Winkel 40, den die beiden Abschnitte 38, 39 einschließen, zwischen den Haupterstreckungsgeraden der Abschnitte 38, 39 gemessen.

Es ist bevorzugt, dass der Übergang zwischen den Abschnitten 38, 39 einem scharfen Knick aufweist. Dies ist jedoch ebenfalls nicht unbedingt und nicht in allen Fällen erforderlich. Beispielsweise kann der Knick verrundet sein oder es kann einen anders geformten Abschnitt des Randes als Übergang zwischen den Abschnitten 38, 39 geben. Es ist insbesondere auch möglich, dass die Breite der Hauptauskoppelfläche 3 in diesem Übergangsabschnitt oder in einem Teil dieses Übergangsabschnittes minimal ist oder zumindest ein lokales Minimum aufweist.

In Figur 3 sind in die Hauptauskoppelfläche eine Mehrzahl von Bereichen eingezeichnet, die eine unterschiedlich hohe Bestrahlungsstärke oder Beleuchtungsstärke aufweisen. Die eingezeichneten Grenzen der Bereiche verlaufen in etwa entlang Linien mit gleicher Beleuchtungsstärke oder Bestrahlungsstärke. Die Hauptauskoppelfläche und die Kontaktflächen sind so ausgebildet wie bei den anhand der Figuren 1 und 2 veranschaulichten Ausführungsbeispielen.

Ein erster Bereich 33 der Hauptauskoppelfläche weist eine höchste Bestrahlungsstärke oder Beleuchtungsstärke auf. Je weiter die übrigen Bereiche 34, 35, 36, 37 von dem ersten Bereich 33 entfernt sind, desto geringer ist ihre Bestrahlungsstärke oder Beleuchtungsstärke. Die Bestrahlungsstärke des ersten Bereichs 33 ist beispielsweise mindestens sechs mal oder mindestens acht mal so groß wie die des äußersten Bereichs 37.

In Figur 3 ist deutlich zu erkennen, dass die Hauptauskoppelfläche des Lumineszenzdiodenchips eine sehr inhomogene Strahldichte- oder Leuchtdichteverteilung emittiert. Diese inhomogene Strahldichte- oder Leuchtdichteverteilung ist gezielt durch eine inhomogene Verteilung der Flächendichte der Kontaktflächen und die damit verbundene inhomogene Stromdichteverteilung in der Halbleiterschichtenfolge realisiert.

Mit einem derartigen Lumineszenzdiodenchip kann auf technisch einfache Weise ein Scheinwerfer für ein Abblendlicht eines Kraftfahrzeugs realisiert werden. Insbesondere kann eine für derartige für Scheinwerfer vorgeschriebene Strahldichte- oder Leuchtdichteverteilung grundsätzlich durch eine einfache Abbildung der Hauptauskoppelfläche 3 mittels einer Abbildungsoptik 50 realisiert werden. Siehe hierzu Figur 4, in der ein Lumineszenzdiodenchip 101 und eine Abbildungsoptik 50 in einer Seitenansicht schematisch dargestellt sind.

Auf aufwändige spezielle Optiken, mittels denen zum Beispiel ein weitgehend homogener Scheinwerferkegel derart "geformt" wird, dass er mit einer sehr viel inhomogeneren Strahldichte- oder Leuchtdichteverteilung aus der Optik emittiert wird, kann mit Vorteil grundsätzlich verzichtet werden. Es können natürlich dennoch Optiken verwendet werden, mittels denen die Strahldichteverteilung beeinflusst wird. Derartige etwaige Optiken können jedoch wesentlich einfacher entwickelt und hergestellt werden, da zumindest eine grobe Strahldichteverteilung bereits durch das Design des Lumineszenzdiodenchips realisiert werden kann.

Grundsätzlich können die in den Figuren 1 bis 3 dargestellten Lumineszenzdiodenchips auch "spiegelverkehrt" ausgebildet werden, in dem Sinne, dass die in den Figuren dargestellten Formen und Strukturen an einem der beiden Querränder (d.h. der Ränder des Chips, die in Draufsicht entlang der Breite der Hauptauskoppelfläche verlaufen) gespiegelt sind.

In Figur 5 ist eine resultierende Bestrahlungsstärke oder Beleuchtungsstärke eines von der Abbildungsoptik 50 in Figur 4 emittierten Strahlenkegels auf eine senkrecht zur Hauptabstrahlrichtung verlaufende Ebene dargestellt. Es ist zu erkennen, dass eine scharfe Hell-Dunkel-Grenze an der Oberseite realisiert ist. Die Hell-Dunkel-Grenze weist zudem einen Abschnitt auf, der um etwa 15° zu einem anderen Abschnitt oder zu einer Horizontalen verkipppt ist.

In Figur 5 sind Bereiche angezeichnet, die in etwa den in Figur 3 eingezeichneten Bereichen entsprechen. Ein erster Bereich 33 weist eine höchste Bestrahlungsstärke oder Beleuchtungsstärke auf. Je weiter die Bereiche vom ersten Bereich 33 entfernt sind, desto geringer ist die in ihnen gemessene Bestrahlungsstärke oder Beleuchtungsstärke.

Bei dem in Figur 6 dargestellten Ausschnitt eines beispielhaften Lumineszenzdiodenchips in einer schematischen seitlichen Schnittansicht ist eine Halbleiterschichtenfolge 10 enthalten. Die Halbleiterschichtenfolge 10 umfasst eine aktive Schicht 11, eine p-leitend dotierte Halbleiterschicht 13 und eine n-leitend dotierte Halbleiterschicht 12. Jede dieser Schichten 11, 12, 13 der Halbleiterschichtenfolge 10 kann insbesondere aus mehreren Teilschichten zusammen gesetzt sein, die insbesondere auch unterschiedliche Materialzusammensetzungen aufweisen können.

Die Halbleiterschichtenfolge weist beispielsweise III/V-Verbindungs-Halbleitermaterialien auf. Ein III/V-Verbindungs-Halbleitermaterial weist wenigstens ein Element aus der dritten Hauptgruppe, wie beispielsweise B, Al, Ga, In, und ein Element aus der fünften Hauptgruppe, wie beispielsweise N, P, As, auf. Insbesondere umfasst der Begriff "III/V-Verbindungs-Halbleitermaterial" die Gruppe der binären, ternären oder quaternären Verbindungen, die wenigstens ein Element aus der dritten Hauptgruppe und wenigstens ein Element aus der fünften Hauptgruppe enthalten, beispielsweise Nitrid- und Phosphid-Verbindungshalbleiter. Eine solche binäre, ternäre oder quaternäre Verbindung kann zudem zum Beispiel ein oder mehrere Dotierstoffe sowie zusätzliche Bestandteile aufweisen.

Die aktive Schicht 11 umfasst bevorzugt einen pn-Übergang, eine Doppelheterostruktur, einen Einfach-Quantentopf (SQW, single quantum well) oder, besonders bevorzugt, eine Mehrfach-Quantentopfstruktur (MQW, multi quantum well) zur Strahlungserzeugung. Die Bezeichnung Quantentopfstruktur entfaltet hierbei keine Bedeutung hinsichtlich der Dimensionalität der Quantisierung. Sie umfasst somit u.a. Quantentröge, Quantendrähte und Quantenpunkte und jede Kombination dieser Strukturen. Beispiele für MQW-Strukturen sind dem Fachmann bekannt.

Der Lumineszenzdiodenchip ist zum Beispiel ein Dünnfilm-Leuchtdiodenchip. Insbesondere weist er an seiner Rückseite ein Trägersubstrat auf. Bei einer Ausgestaltung sind die erste und die zweite elektrische Anschlussschicht zumindest stellenweise zwischen der Halbleiterschichtenfolge und dem Trägersubstrat angeordnet.

Ein Dünnfilm-Leuchtdiodenchip zeichnet sich durch mindestens eines der folgenden charakteristischen Merkmale aus:
- an einer zu einem Trägerelement, insbesondere dem Trägersubstrat, hingewandten Hauptfläche der Halbleiterschichtenfolge, bei der es sich insbesondere um eine Epitaxie-Schichtenfolge handelt, ist eine reflektierende Schicht aufgebracht oder ausgebildet, die zumindest einen Teil der in der Halbleiterschichtenfolge erzeugten elektromagnetischen Strahlung in diese zurückreflektiert;
- der Dünnfilm-Leuchtdiodenchip weist ein Trägerelement auf, bei dem es sich nicht um das Wachstumssubstrat handelt, auf dem die Halbleiterschichtenfolge epitaktisch gewachsen wurde, sondern um ein separates Trägerelement, das nachträglich an der Halbleiterschichtenfolge befestigt wurde;
- die Halbleiterschichtenfolge weist eine Dicke im Bereich von 20 µm oder weniger, insbesondere im Bereich von 10 µm oder weniger auf;
- die Halbleiterschichtenfolge ist frei von einem Aufwachssubstrat. Vorliegend bedeutet "frei von einem Aufwachssubstrat, dass ein gegebenenfalls zum Aufwachsen benutztes Aufwachssubstrat von der Halbleiterschichtenfolge entfernt oder zumindest stark gedünnt ist. Insbesondere ist es derart gedünnt, dass es für sich oder zusammen mit der Epitaxie-Schichtenfolge alleine nicht freitragend ist. Der verbleibende Rest des stark gedünnten Aufwachssubstrats ist insbesondere als solches für die Funktion eines Aufwachssubstrates ungeeignet; und
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, das heißt, sie weist ein möglichst ergodisch stochastisches Streuverhalten auf.

Ein Dünnfilm-Leuchtdiodenchip ist in guter Näherung ein Lambert'scher Oberflächenstrahler und eignet sich von daher beispielsweise gut für die Anwendung in einem Scheinwerfer, etwa einem Kraftfahrzeugscheinwerfer.

Die Halbleiterschichtenfolge 10 weist bei dem in Figur 6 veranschaulichten Beispiel auf einer in Hauptabstrahlrichtung gewandten Vorderseite eine Hauptauskoppelfläche 31 auf. Auf einer der Vorderseite gegenüberliegenden Rückseite der Halbleiterschichtenfolge sind eine erste elektrische Anschlussschicht 20 und eine zweite elektrische Anschlussschicht 25 angeordnet. Die erste elektrische Anschlussschicht 20 und die zweite elektrische Anschlussschicht 25 sind elektrisch voneinander isoliert, beispielsweise mittels einer elektrisch isolierenden Schicht 23.

Die erste elektrische Anschlussschicht 20 und die zweite elektrische Anschlussschicht 25 überlappen lateral miteinander. Bei dem in Figur 6 dargestellten Ausführungsbeispiel überlappt auch die elektrisch isolierende Schicht 23 mit den elektrischen Anschlussschichten 20, 25 lateral. Lateral bedeutet, in Richtung parallel zu einer Haupterstreckungsebene der Halbleiterschichtenfolge.

Auf ihrer Rückseite weist die Halbleiterschichtenfolge 10 einen Durchbruch auf, der sich durch die aktive Schicht 11 hindurch erstreckt. Der Durchbruch ist beispielsweise in Form einer Ausnehmung ausgebildet. Ein Teilbereich 22 der ersten elektrischen Anschlussschicht 20 erstreckt sich von der Rückseite durch den Durchbruch der aktiven Schicht hindurch in Richtung zu der Hauptauskoppelfläche hin. In dem Durchbruch berührt der Teilbereich 22 die n-leitend dotierte Halbleiterschicht 12 mit mindestens einer Kontaktfläche 21.

Beispielsweise sind alle Kontaktfläche 21 des Lumineszenzdiodenchips auf diese Weise hergestellt. Das heißt, jede der Kontaktfläche 21 der ersten elektrischen Anschlussschicht 20 ist durch einen Teilbereich 22 gebildet, der sich von der Rückseite der Halbleiterschichtenfolge durch einen Durchbruch der aktiven Schicht hindurch in Richtung zu der Hauptauskoppelfläche hin erstreckt und eine Schicht der Halbleiterschichtenfolge 10 berührt. Der Teilbereich 22 ist elektrisch gegenüber der aktiven Schicht 11 und der p-leitend dotierten Halbleiterschicht 13 isoliert, beispielsweise mittels der elektrisch isolierenden Schicht 23.

Der Durchbruch ist in Form einer Vertiefung ausgebildet, die beispielsweise die Form eines Kreiszylinders oder eines elliptischen Zylinders, eines Quaders, eines Kegels, oder Kegelstumpfs, einer Pyramide oder eines Pyramidenstumpfs aufweist. Alternativ kann die Vertiefung auch als Graben mit einer lang gestreckten Form ausgebildet sein. Vorzugsweise hat der Graben eine im Wesentlichen ebene Bodenfläche. Bei einer Ausgestaltung vergrößert sich der Querschnitt des Grabens von der Bodenfläche zu seiner Öffnung hin. Die Ausnehmung ist beispielsweise mittels Ätzen erzeugt.

Der Querschnitt der Ausnehmung verjüngt sich von der Öffnung in Richtung zum Boden. Entsprechend verjüngt sich auch der Teilbereich 22 der ersten elektrischen Anschlussschicht 20 im Verlauf von der Rückseite der Halbleiterschichtenfolge zu der Kontaktfläche 21 hin. Im Bereich der Rückseite weist der Teilbereich 22 beispielsweise eine laterale Ausdehnung 220 aus einem Bereich zwischen einschließlich 1 µm und einschließlich 40 µm auf. Beispielsweise beträgt die laterale Erstreckung 220 5 µm, 10 µm, 15 µm, 25 µm oder 35 µm. Die entsprechende laterale Erstreckung der Kontaktfläche 21 ist zum Beispiel zwischen einschließlich 10% und einschließlich 50% kleiner als die laterale Erstreckung des Teilbereichs im Bereich der Rückseite der Halbleiterschichtenfolge.

Die Hauptauskoppelfläche 31 der Halbleiterschichtenfolge 10 weist eine Strukturierung mit Struktureinheiten 30 auf. Die Struktureinheiten 30 weisen beispielsweise eine erste laterale Erstreckung, eine senkrecht zur ersten lateralen Erstreckung gemessene zweite laterale Erstreckung und eine vertikale Erstreckung auf, die jeweils in einem Bereich zwischen einschließlich 0,1 µm und einschließlich 2,5 µm liegen. Die Sttruktureinheiten können unterschieldlich groß und unterschieldlich geformt sein. Sie sind geeignet, die Auskopplung von elektromagnetischer Strahlung aus der Halbleiteschichtenfolge 10 zu beeinflussen.

Auf der Hauptauskoppelfläche 31 der Halbleiterschichtenfolge 10 ist eine Lumineszenzkonversionsschicht 60 aufgebracht. Diese weist mindestens einen Leuchtstoff auf, der geeignet ist, die in der aktiven Schicht 11 erzeugte elektromagnetische Strahlung zumindest teilweise in eine elektromagnetische Strahlung eines veränderten Wellenlängenbereichs zu konvertieren. Eine von der Halbleiterschichtenfolge 10 abgewandte Außenfläche der Lumineszenzkonversionsschicht 60 bildet beispielsweise die Hauptauskoppelfläche 32 des Lumineszenzdiodenchips.

Die Hauptauskoppelfläche 31 der Halbleiterschichtenfolge 10 und die Hauptauskoppelfläche 32 des Lumineszenzdiodenchips weisen beispielsweise in Draufsicht eine gleiche Form auf. Es ist möglich, dass die gesamte Hauptauskoppelfläche 32 des Lumineszenzdiodenchips durch eine Außenfläche eines auf die Halbleiterschichtenfolge 10 aufgebrachten Materials, beispielsweise einer Lumineszenzkonversionsschicht 60 gebildet ist. Alternativ ist es jedoch auch möglich, dass nur ein Teil der Hauptauskoppelfläche durch ein derartiges Material gebildet ist und ein weiterer Teil zum Beispiel durch frei liegende Bereiche der Hauptauskoppelfläche 31 der Halbleiterschichtenfolge 10 gebildet ist.

Für die Lumineszenzkonversionsschicht 60 eignen sich alle für die Anwendung bei LEDs bekannten Leuchtstoffe. Beispiele für derartige Leuchtstoffe und Leuchtstoffmischungen sind:
- Chlorosilikate,
- Orthosilikate, Sulfide, Thiometalle und Vanadate,
- Aluminate, Oxide, Halophosphate,
- Nitride, Sione und Sialone, und
- Granate der Seltenen Erden, wie mit Cer dotiertes Yttrium-Aluminium-Granat, und der Erdalkalielemente.
Die von der Halbleiterschichtenfolge 10 emittierte elektromagnetische Strahlung wird durch die Struktureinheiten 30 und die Lumineszenzkonversionsschicht 60 gestreut. Dadurch erscheinen diejenigen Bereiche, die oberhalb der Teilbereiche 22 der ersten elektrischen Anschlussschicht 20 liegen, nicht oder nur geringfügig als verdunkelt im Vergleich zu angrenzenden Bereichen der Hauptauskoppelfläche 32.

Die Halbleiterschichtenfolge weist beispielsweise eine Höhe 100 aus einem Bereich zwischen einschließlich 3 µm und einschließlich 5 µm auf. Die Lumineszenzkonversionsschicht 60 weist beispielsweise eine Dicke 61 aus einem Bereich zwischen einschließlich 15 µm und einschließlich 30 µm auf.

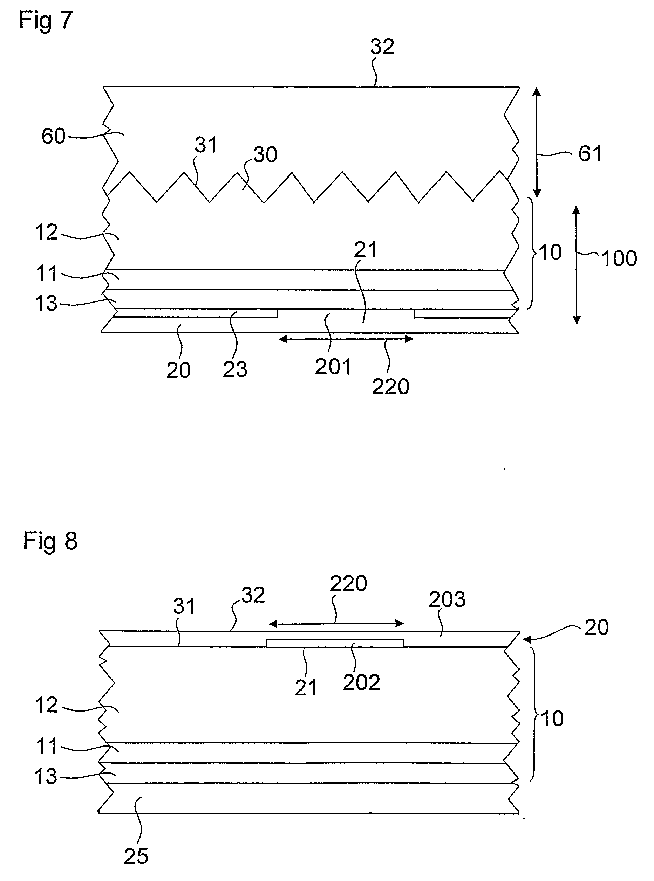

Bei dem in Figur 7 veranschaulichten Ausführungsbeispiel weist die erste elektrische Anschlussschicht 20 keinen Teilbereich auf, der sich durch einen Durchbruch durch die aktive Schicht 11 erstreckt. Stattdessen sind die elektrischen Anschlussflächen 21 der ersten elektrischen Anschlussschicht 20 beispielsweise an der Rückseite der Halbleiterschichtenfolge 10 angeordnet. Die elektrischen Anschlussflächen 21 berühren und kontaktieren zum Beispiel eine p-leitend dotierte Halbleiterschicht 13 der Halbleiterschichtenfolge 10.

Eine Mehrzahl elektrischer Kontaktflächen 21 ist beispielsweise mit Hilfe einer elektrisch isolierenden Schicht 23 ausgebildet. Die elektrisch isolierende Schicht 23 weist in den Bereichen, in denen elektrische Kontaktflächen 21 vorgesehen sind, Ausnehmungen auf. Ein Teilbereich 201 der ersten elektrischen Anschlussschicht erstreckt sich jeweils in diese Ausnehmung hinein und bildet eine elektrische Kontaktfläche 21 an der Halbleiterschichtenfolge 10 aus.

Ein Beispiel für ein elektrisch isolierendes Material ist Silizium-Dioxid. Die elektrischen Kontaktflächen können zum Beispiel gebräuchliche Metalle aufweisen. Zusätzlich oder alternativ können die elektrischen Anschlussflächen auch transparente, elektrisch leitfähige Oxide (transparent conductive oxides, TCO) aufweisen, wie Indium-Zinn-Oxid oder Zink-Oxid.

Die Öffnung in der elektrisch isolierenden Schicht 23 weist beispielsweise eine laterale Ausdehnung 220 zwischen einschließlich 1 µm und einschließlich 40 µm oder zwischen einschließlich 1 µm und einschließlich 20 µm auf. Eine entsprechende laterale Ausdehnung der elektrischen Kontaktfläche 21 ist in etwa genau so groß wie die laterale Ausdehnung 220 der Öffnung der elektrisch isolierenden Schicht 23.

Bei dem in Figur 7 veranschaulichten Ausführungsbeispiel kann eine zweite elektrische Anschlussschicht an der Vorderseite der Halbleiterschichtenfolge 10 angeordnet sein, was jedoch nicht dargestellt ist.

Bei dem in Figur 8 dargestellten Ausführungsbeispiel ist die erste elektrische Anschlussschicht 20 an der Vorderseite der Halbleiterschichtenfolge 10 des Lumineszenzdiodenchips angeordnet. Die erste elektrische Anschlussschicht 20 weist eine erste Teilschicht 203 auf, die für die von der aktiven Schicht 11 emittierte elektromagnetische Strahlung durchlässig ist. Die erste Teilschicht 203 bildet zum Beispiel mit der angrenzenden n-leitend dotierten Halbleiterschicht 12 keinen oder nur einen vergleichsweise schlecht leitenden elektrischen Kontakt aus. Sie weist beispielsweise ein TCO wie Indium-Zinn-Oxid oder Zink-Oxid auf.

Ein gut leitfähiger elektrischer Kontakt zwischen der ersten elektrischen Anschlussschicht 20 und der Halbleiterschichtenfolge 10 wird mittels einer zweiten Teilschicht 202 der ersten elektrischen Anschlussschicht 20 ausgebildet. Die zweite Teilschicht 202 ist zum Beispiel zwischen der ersten Teilschicht 03 und der Halbleiterschichtenfolge 10 angeordnet. Dort, wo die zweite Teilschicht 202 die Halbleiterschichtenfolge 10 berührt, ist eine elektrische Kontaktfläche 21 ausgebildet. Die zweite Teilschicht 202 berührt beispielsweise die n-leitend dotierte Halbleiterschicht 122.

Der Lumineszenzdiodenchip weist bevorzugt eine Vielzahl derartiger zweiter Teilschichten 202 auf. Die zweite Teilschicht 202 ist beispielsweise durch eine sehr dünne Metallschicht gebildet. Diese kann zum Beispiel nur wenige Nanometer, z.B. 2 nm, 4 nm oder 5 nm dick sein. Alternativ ist es auch möglich, dass die elektrischen Kontaktflächen 21 ohne Hilfe derartiger zweiter Teilschichten 202 der ersten elektrischen Anschlussschicht 20 ausgebildet sind. Dies kann beispielsweise durch eine entsprechende Präparierung der Oberfläche der zu kontaktierenden Halbleiterschichtenfolge 10 erfolgen. Beispielsweise kann die Halbleiteroberfläche in den Bereichen, in denen eine Ausbildung einer elektrischen Kontaktfläche 21 unerwünscht ist, derart aufgeraut werden, dass sich nur ein sehr schlecht oder nicht leitfähiger elektrischer Kontakt zwischen der ersten Teilschicht 203 der strahlungsdurchlässigen ersten elektrischen Anschlussschicht 20 und dem Halbleitermaterial ausbildet. In den Bereichen, in denen eine elektrische Kontaktfläche gewünscht ist, ist die Halbleiteroberfläche vergleichsweise glatt, so dass sich ein gut elektrisch leitfähiger Kontakt zwischen der ersten Teilschicht 203 der strahlungsdurchlässigen ersten elektrischen Anschlussschicht 20 und dem Halbleitermaterial ausbildet.

Bei dem in Figur 8 dargestellten Ausführungsbeispiel kann die erste elektrische Anschlussschicht 20 gemäß einer Ausgestaltung ein Bond-Pad 26 aufweisen, das als Strahlungsblende dient. Eine Ausführungsform des Lumineszenzdiodenchips mit solch einem Bond-Pad 26 ist vorhergehend im Zusammenhang mit Figur 2 beschrieben worden. Das Bond-Pad 26 ist beispielsweise mit der ersten strahlungsdurchlässigen Teilschicht 203 der ersten elektrischen Anschlussschicht 20 elektrisch leitend verbunden.

Eine zweite elektrische Anschlussschicht 25 ist bei dem in Figur 8 veranschaulichten Ausführungsbeispiel an der Rückseite der Halbleiterschichtenfolge 10 angeordnet.

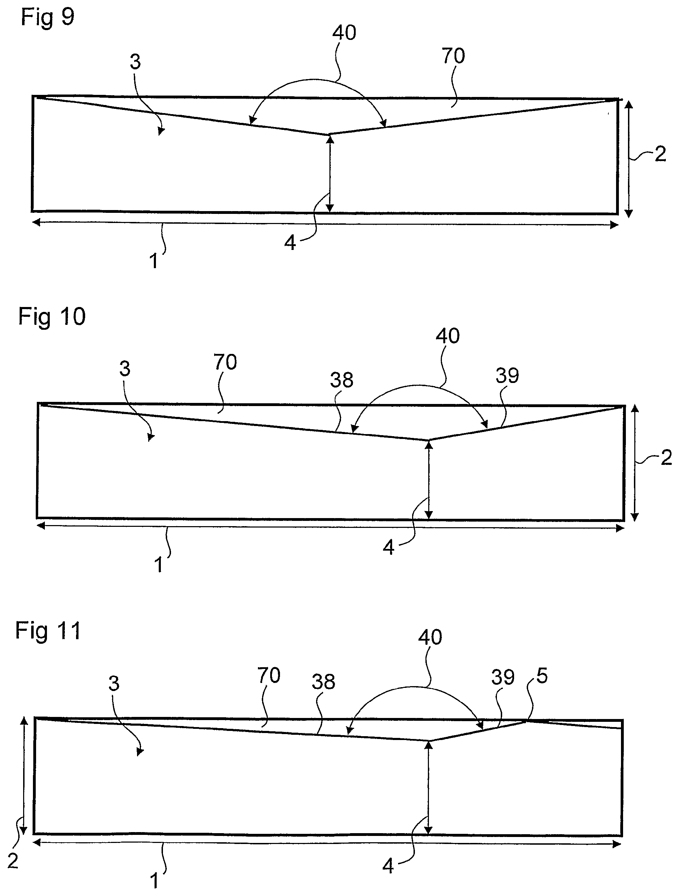

In den Figuren 9 bis 13 sind fünf verschiedene Ausführungsbeispiele von Lumineszenzdiodenchips mit unterschiedlich geformter Hauptauskoppelfläche 3 dargestellt. Die in den Figuren 9 bis 12 dargestellten Lumineszenzdiodenchips weisen jeweils eine Hauptauskoppelfläche 3 mit einer langgestreckten Form auf, die von einer rechteckigen Form durch mindestens eine Aussparung 70 abweicht. Die Aussparung 70 weist beispielsweise die Form eines Dreieckes oder eine Form in der Art eines Dreieckes auf. Der Einfachheit halber ist im Folgenden jedoch nur der Ausdruck "dreiecksförmige Aussparung" verwendet.

Bei den in den Figuren 9 und 10 dargestellten Ausführungsbeispielen erstreckt sich die Aussparung 70 zum Beispiel über die gesamte Länge 1 des Lumineszenzdiodenchips. Zwei Schenkel der dreiecksförmigen Aussparung 70 bilden jeweils Randteile der Hauptauskoppelfläche 3.

Bei dem in Figur 9 dargestellten Ausführungsbeispiel sind diese Schenkel nahezu gleichgroß. Sie weichen beispielsweise um weniger als 20% voneinander ab. Bei den in den Figuren 10 bis 12 dargestellten Ausführungsbeispielen weisen diese Schenkel stark unterschiedlich große Längen auf. Beispielsweise ist einer der Schenkel zwischen einschließlich zwei und einschließlich fünf mal so groß wie der andere der Schenkel der dreiecksförmigen Aussparung 70.

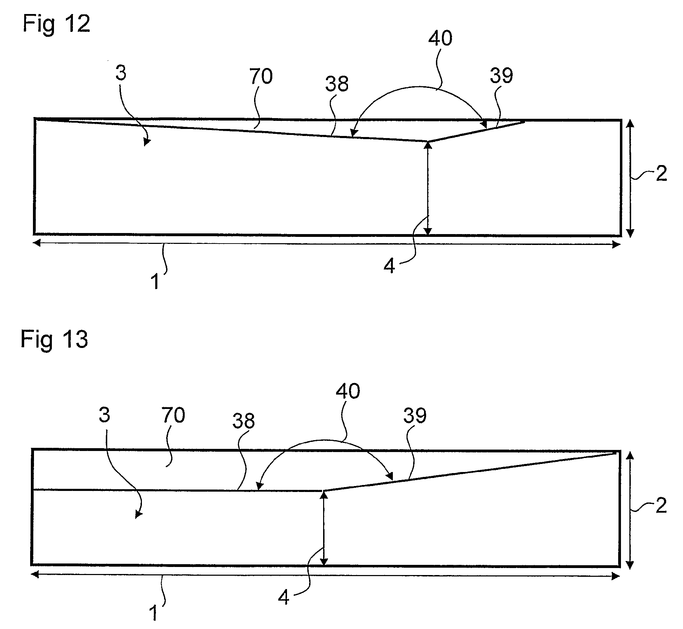

Bei dem in Figur 10 dargestellten Ausführungsbeispiel ist der eine Schenkel der Aussparung 70 beispielsweise doppelt so groß wie der andere Schenkel. Bei den in den Figuren 11 und 12 dargestellten Ausführungsbeispielen ist der eine Schenkel der dreieckfömigen Aussparung 70 beispielsweise vier mal so groß wie der andere Schenkel.

Das in Figur 11 dargestellte Ausführungsbeispiel des Lumineszenzdiodenchips weist in Draufsicht eine Hauptauskoppelfläche auf, die nicht nur durch eine dreiecksförmige Aussparung 70, sondern auch durch eine zweite, deutlich kleinere Aussparung von einer rechteckigen Form abweicht. Beide Aussparungen sind auf der selben Hauptseite der Hauptauskoppelfläche eingebracht. Beispielsweise grenzen sie aneinander. Zwischen den Aussparungen weist die Hauptauskoppelfläche 3 einen Punkt 5 oder einen Bereich auf, in dem die Hauptauskoppelfläche eine maximale Breite 2 aufweist. Ausgehend von diesem Punkt oder Bereich, wo die Breite eine Maximum aufweist, nimmt die Breite der Hauptauskoppelfläche 3 in beiden Richtungen entlang der Längenstrecke 1 zunehmend ab.

Bei dem Ausführungsbeispiel gemäß Figur 13 weicht die Form der Hauptauskoppelfläche 3 in Draufsicht nicht durch eine dreiecksförmige, sondern durch eine viereckige Aussparung 70 von der Form eines Rechteckes ab. Die Breite der langgestreckten Hauptauskoppelfläche 3 ist auf einer Seite minimal und bleibt im Verlauf zur anderen Seite hin konstant. In einem Bereich, der z.B. zwischen einschließlich 40% und einschließlich 60% der Länge 1 der Hauptauskoppelfläche 3 entspricht, weist die Form einen Knick auf, ab dem die Breite im weiteren Verlauf zunimmt.

Die viereckige Ausnehmung 70, durch die die Form der Haupauskoppelfläche 3 des in Figur 13 dargestellten Ausführungsbeispiels von der Form eines Rechteckes abweicht, ist deutlich größer als die dreiecksförmigen Ausnehmungen 70 der in den Figuren 9 bis 12 dargestellten Ausführungsbeispiele. Das bedeutet, dass bei der Herstellung der in den Figuren 9 bis 12 veranschaulichten Lumineszenzdiodenchips in der Regel deutlich mehr aktive Schicht eines Halbleiterschichtenfolgen-Wafers ausgenutzt werden kann als bei dem Beispiel gemäß Figur 13.

Alternativ kann der Lumineszenzdiodenchip bei den Ausführungsbeispielen gemäß der Figuren 9 bis 13 in dem Bereich der Aussparung 70 keine Aussparung, sondern einen durch ein Bondpad überdeckten Teil der Halbleiterschichtenfolge aufweisen. Das Bondpad wirkt in diesem Fall als Blende. Es begrenzt die Hauptauskoppelfläche 3 auf einer Hauptseite.

## Patentansprüche

1. Lumineszenzdiodenchip mit einer Halbleiterschichtenfolge, die eine zur Erzeugung von elektromagnetischer Strahlung geeignete aktive Schicht aufweist, und einer ersten elektrischen Anschlussschicht, die die Halbleiterschichtenfolge mit einer Mehrzahl von Kontaktflächen berührt und elektrisch leitend kontaktiert,
wobei eine inhomogene Stromdichteverteilung in der Halbleiterschichtenfolge durch eine inhomogene Verteilung einer Flächendichte der Kontaktflächen entlang einer Haupterstreckungsebene der Halbleiterschichtenfolge derart eingestellt ist, dass ein erster Bereich einer Hauptauskoppelfläche der Halbleiterschichtenfolge oder des Lumineszenzdiodenchips eine mindestens drei Mal so hohe Bestrahlungsstärke oder Beleuchtungsstärke aufweist wie mindestens ein zweiter Bereich der Hauptauskoppelfläche der Halbleiterschichtenfolge oder des Lumineszenzdiodenchips, wobei Teilflächen, die von einer strahlungsundurchlässigen oder zu mehr als 50% strahlungsabsorbierenden Schicht bedeckt sind, nicht zur Hauptauskoppelfläche zählen.

2. Lumineszenzdiodenchip nach Anspruch 1,
wobei die Bestrahlungsstärke oder Beleuchtungsstärke des ersten Bereichs der Hauptauskoppelfläche mindestens fünf mal, bevorzugt mindestens zehn ma1 so groß ist wie die des zweiten Bereichs.

3. Lumineszenzdiodenchip nach einem der vorhergehenden Ansprüche,
wobei die erste Anschlussschicht mindestens 10, bevorzugt mindestens 25, besonders bevorzugt mindestens 50 Kontaktflächen aufweist.

4. Lumineszenzdiodenchip nach einem der vorhergehenden Ansprüche,
wobei die inhomogene Stromverteilung auch eine unsymmetrische Stromverteilung in der Halbleiterschichtenfolge ist, die durch eine unsymmetrische Verteilung der Flächendichte der Kontaktflächen entlang einer Haupterstreckungsebene der Halbleiterschichtenfolge eingestellt ist.

5. Lumineszenzdiodenchip nach einem der vorhergehenden Ansprüche,
wobei die Hauptauskoppelfläche in Draufsicht eine langgestreckte Form aufweist und bei einer gedachten Unterteilung der Hauptauskoppelfläche in zwei Hälften, mit einer Grenzgeraden, die eine Längenstrecke der Hauptauskoppelfläche senkrecht in der Mitte schneidet, die summierte Fläche oder die Anzahl der Kontaktflächen in Draufsicht im Bereich von einer der Hälften um mindestens 15%, bevorzugt um mindestens 20% größer ist als im Bereich der anderen Hälfte.

6. Lumineszenzdiodenchip nach einem der vorhergehenden Ansprüche,
wobei die Hauptauskoppelfläche in Draufsicht eine langgestreckte Form aufweist und bei einer gedachten Unterteilung der Hauptauskoppelfläche in drei Drittel, mit Grenzgeraden, die eine Längenstrecke der Hauptauskoppelfläche senkrecht bei einem Drittel und bei zwei Drittel der Gesamtlänge schneiden, die summierte Fläche oder die Anzahl der Kontaktflächen in Draufsicht in dem Bereich des mittleren Drittels um mindestens 30%, bevorzugt um mindestens 45%, besonders bevorzugt um mindestens 65% größer ist als jeweiils in den Bereichen der äußeren beiden Drittel.

7. Lumineszenzdiodenchip nach einem der vorhergehenden Ansprüche,
wobei die Hauptauskoppelfläche in Draufsicht eine unsymmetrische Form aufweist.

8. Lumineszenzdiodenchip nach einem der vorhergehenden Ansprüche,
wobei die Hauptauskoppelfläche in Draufsicht zwei Abschnitte eines Randes aufweist, die an der Außenseite der Hauptauskoppelfläche einen Winkel zwischen einschließlich 155° und einschließlich 175° einschließen.

9. Lumineszenzdiodenchip nach einem der vorhergehenden Ansprüche,
wobei der erste Bereich der Hauptauskoppelfläche an einen der zwei Abschnitte des Randes angrenzt oder höchstens 50 µm von einem der zwei Abschnitte beabstandet ist.

10. Lumineszenzdiodenchip nach einem der vorhergehenden Ansprüche,
wobei die Hauptauskoppelfläche in Draufsicht eine langgestreckte Form aufweist und ihre Breite an einer Stelle oder in einem Bereich ein zumindest lokales Minimum hat, wobei der Stelle oder dem Bereich in beiden Richtungen entlang der Länge der Hauptauskoppelfläche Abschnitte mit zunehmend größer werdender Breite folgen.

11. Lumineszenzdiodenchip nach einem der vorhergehenden Ansprüche,
wobei die erste elektrische Anschlussschicht auf einer der Hauptauskoppelfläche abgewandten Rückseite der Halbleiterschichtenfolge angeordnet ist.

12. Lumineszenzdiodenchip nach einem der vorhergehenden Ansprüche,
wobei eine zweite elektrische Anschlussschicht vorhanden ist, die ebenfalls auf der Rückseite der Halbleiterschichtenfolge angeordnet ist, lateral mit der ersten elektrischen Anschlussschicht überlappt und elektrisch gegen die erste elektrische Anschlussschicht isoliert ist, und sich mindestens ein Teilbereich der ersten elektrischen Anschlussschicht von der Rückseite durch einen Durchbruch der aktiven Schicht hindurch in Richtung zu der Hauptauskoppelfläche hin erstreckt.

13. Lumineszenzdiodenchip nach einem der Ansprüche 1 bis 10, wobei eine zweite elektrische Anschlussschicht vorhanden ist und die erste und die zweite elektrische Anschlussschicht auf einander gegenüberliegenden Seiten der Halbleiterschichtenfolge angeordnet sind.

14. Lumineszenzdiodenchip nach einem der vorhergehenden Ansprüche,
wobei die Hauptauskoppelfläche der Halbleiterschichtenfolge eine Strukturierung mit Struktureinheiten aufweist, die eine erste laterale Erstreckung, eine senkrecht zur ersten lateralen Erstreckung gemessene zweite laterale Erstreckung und/oder eine vertikale Erstreckung aufweisen, die größer oder gleich dem 0,2-fachen einer Wellenlänge des Emissionsmaximums der elektromagnetischen Strahlung und kleiner oder gleich dem 5-fachen einer Wellenlänge des Emissionsmaximums der elektromagnetischen Strahlung ist.

15. Lumineszenzdiodenchip nach einem der vorhergehenden Ansprüche,
wobei ein vom dem Lumineszenzdiodenchip emmittierter Strahlungskegel eine Strahldichteverteilung aufweist, die einer Strahldichteverteilung für ein Abblendlicht eines Kraftfahrzeuges entspricht.

## Claims

1. Luminescence diode chip comprising a semiconductor layer sequence having an active layer suitable for generating electromagnetic radiation, and a first electrical connection layer, which touches and makes electrically conductive contact with the semiconductor layer sequence with a plurality of contact areas,
wherein an inhomogeneous current density distribution is set in the semiconductor layer sequence by means of an inhomogeneous distribution of an area density of the contact areas along a main plane of extent of the semiconductor layer sequence in such a way that a first region of a main coupling-out area of the semiconductor layer sequence or of the luminescence diode chip has an irradiance or illuminance at least three times as high as that of at least one second region of the main coupling-out area of the semiconductor layer sequence or of the luminescence diode chip, wherein partial areas which are covered by a radiation-opaque layer or layer that absorbs radiation to the extent of more than 50% do not belong to the main coupling-out area.

2. Luminescence diode chip according to Claim 1,
wherein the irradiance or illuminance of the first region of the main coupling-out area is at least five times, preferably at least ten times, as great as that of the second region.

3. Luminescence diode chip according to either of the preceding claims,
wherein the first connection layer has at least 10, preferably at least 25, particularly preferably at least 50, contact areas.

4. Luminescence diode chip according to any of the preceding claims,
wherein the inhomogeneous current distribution is also an asymmetrical current distribution in the semiconductor layer sequence, which is set by means of an asymmetrical distribution of the area density of the contact areas along a main plane of extent of the semiconductor layer sequence.

5. Luminescence diode chip according to any of the preceding claims,
wherein the main coupling-out area has an elongated form in plan view and, in the case of an imaginary subdivision of the main coupling-out area into two halves, with a limiting straight line that intersects a length section of the main coupling-out area perpendicularly in the center, the summed area or the number of contact areas in plan view is greater by at least 15%, preferably by at least 20%, in the region of one of the halves than in the region of the other half.

6. Luminescence diode chip according to any of the preceding claims,
wherein the main coupling-out area has an elongated form in plan view and, in the case of an imaginary subdivision of the main coupling-out area into three thirds, with limiting straight lines that intersect a length section of the main coupling-out area perpendicularly at one third and at two thirds of the total length, the summed area or the number of contact areas in plan view is greater by at least 30%, preferably by at least 45%, particularly preferably by at least 65%, in the region of the central third than in each case in the regions of the outer two thirds.

7. Luminescence diode chip according to any of the preceding claims,
wherein the main coupling-out area has an asymmetrical form in plan view.

8. Luminescence diode chip according to any of the preceding claims,
wherein the main coupling-out area has in plan view two sections of an edge which form an angle of between 155° and 175° inclusive at the outer side of the main coupling-out area.

9. Luminescence diode chip according to any of the preceding claims,
wherein the first region of the main coupling-out area adjoins one of the two sections of the edge or is spaced apart from one of the two sections by at most 50 µm.

10. Luminescence diode chip according to any of the preceding claims,
wherein the main coupling-out area has an elongated form in plan view and its width has an at least local minimum at a location or in a region, wherein sections having a width that becomes increasingly larger follow the location or the region in both directions along the length of the main coupling-out area.

11. Luminescence diode chip according to any of the preceding claims,
wherein the first electrical connection layer is arranged on a rear side of the semiconductor layer sequence, said rear side being remote from the main coupling-out area.

12. Luminescence diode chip according to any of the preceding claims,
wherein a second electrical connection layer is present, which is likewise arranged on the rear side of the semiconductor layer sequence, laterally overlaps the first electrical connection layer and is electrically insulated from the first electrical connection layer, and at least one partial region of the first electrical connection layer extends from the rear side through a perforation of the active layer in the direction toward the main coupling-out area.

13. Luminescence diode chip according to any of claims 1 to 10,
wherein a second electrical connection layer is present and the first and second electrical connection layers are arranged on mutually opposite sides of the semiconductor layer sequence.

14. Luminescence diode chip according to any of the preceding claims,
wherein the main coupling-out area of the semiconductor layer sequence has a structuring with structure units which have a first lateral extent, a second lateral extent, measured perpendicularly to the first lateral extent, and/or a vertical extent, which is greater than or equal to 0.2 times a wavelength of the emission maximum of the electromagnetic radiation and less than or equal to 5 times a wavelength of the emission maximum of the electromagnetic radiation.

15. Luminescence diode chip according to any of the preceding claims,
wherein a radiation cone emitted by the luminescence diode chip has a radiance distribution corresponding to a radiance distribution for a low-beam light of a motor vehicle.

## Revendications

1. Puce de diode électroluminescente comportant une série de couches semi-conductrices qui comprend une couche active appropriée pour générer un rayonnement électromagnétique et une première couche de connexion électrique qui touche et est en contact électriquement conducteur avec la séquence de couches semi-conductrices par l'intermédiaire d'une pluralité de surfaces de contact, dans lequel une distribution de densité de courant inhomogène apparaît dans, la séquence de couches semi-conductrices du fait d'une distribution inhomogène d'une densité surfacique des surfaces de contact le long d'un plan d'extension principal de la séquence de couches semi-conductrices, de telle manière qu'une première région d'une surface de sortie principale de la séquence de couches semi-conductrices ou de la puce de diode électroluminescente présente une intensité de rayonnement ou une intensité d'éclairement au moins trois fois supérieure à celle d'au moins une seconde région de la surface de sortie principale de la séquence de couches semi-conductrices ou de la puce de diode électroluminescente, dans laquelle des surfaces partielles qui sont recouvertes d'une couche transparente au rayonnement ou absorbant le rayonnement à plus de 50 %, ne sont pas prises en compte dans la surface de sortie principale.

2. Puce de diode électroluminescente selon la revendication 1,
dans laquelle l'intensité de rayonnement ou l'intensité d'éclairement de la première région de la surface de sortie principale est au moins cinq fois supérieure, et de préférence au moins dix fois supérieure à celle de la seconde région.

3. Puce de diode électroluminescente selon l'une quelconque des revendications précédentes,
dans laquelle la première couche de connexion comprend au moins 10, et de préférence au moins 25, et plus préférablement, au moins 50 surfaces de contact.

4. Puce de diode électroluminescente selon l'une quelconque des revendications précédentes,
dans laquelle la distribution de courant inhomogène est également une distribution de courant asymétrique dans la séquence de couches semi-conductrices, qui se produit du fait d'une distribution asymétrique de densité surfacique de surface de contact le long d'un plan d'extension principal de la séquence de couches semi-conductrices.

5. Puce de diode électroluminescente selon l'une quelconque des revendications précédentes,
dans laquelle la surface de sortie principale présente en coupe transversale une forme allongée et, lorsqu'on divise de manière imaginaire la surface de sortie principale en deux moitiés par une droite de séparation passant perpendiculairement par le milieu d'une étendue longitudinale de la surface de sortie principale, la surface sommée ou le nombre des surfaces de contact en coupe transversale, dans la région de l'une des moitiés, est supérieur d'au moins 15 % et de préférence d'au moins 20 % à sa valeur dans la région de l'autre moitié.

6. Puce de diode électroluminescente selon l'une quelconque des revendications précédentes,
dans laquelle la surface de sortie principale présente, en coupe transversale, une forme allongée et, lorsqu'on divise de manière imaginaire la surface de sortie principale en trois tiers par des droites de séparation qui coupent perpendiculairement une étendue longitudinale de la surface de sortie principale en un tiers et en deux tiers de la longueur totale, la surface sommée ou le nombre des surfaces de contact, en coupe transversale, dans la région du tiers médian, est supérieur d'au moins 30 %, et de préférence d'au moins 45 % et plus préférablement, d'au moins 65 %, à sa valeur respective dans les régions des deux tiers extérieurs.

7. Puce de diode électroluminescente selon l'une quelconque des revendications précédentes,
dans laquelle la surface de sortie principale en coupe transversale présente une forme asymétrique.

8. Puce de diode électroluminescente selon l'une quelconque des revendications précédentes,
dans laquelle la surface de sortie principale en coupe transversale présente deux sections d'un bord qui couvrent, sur la face extérieure de la surface de sortie principale, un angle compris entre 155° inclus et 175° inclus.

9. Puce de diode électroluminescente selon selon l'une quelconque des revendications précédentes,
dans laquelle la première région de la surface de sortie principale est adjacente à l'une des deux sections du bord ou est espacée de plus 50 µm de l'une des deux sections.

10. Puce de diode électroluminescente selon l'une quelconque des revendications précédentes,
dans laquelle la surface de sortie principale en coupe transversale présente une forme allongée et sa largeur en un point ou dans une région présente au moins un minimum local, dans laquelle le point ou la région sont suivis dans les deux directions orientées suivant la longueur de la surface de sortie principale, des sections croissant progressivement.

11. Puce de diode électroluminescente selon l'une quelconque des revendications précédentes,
dans laquelle la première couche de connexion électrique est disposée sur une surface arrière opposée à la surface de sortie principale de la séquence de couches semi-conductrices.

12. Puce de diode électroluminescente selon l'une quelconque des revendications précédentes, dans laquelle il est prévu une seconde couche de connexion électrique qui est éventuellement disposée sur la face arrière de la séquence de couches semi-conductrices, qui chevauche latéralement la première couche de connexion électrique et qui est isolée électriquement de la première couche de connexion électrique, et qui s'étend au moins dans une région partielle de la première couche de connexion électrique depuis la face arrière, à travers une traversée ménagée dans la couche active, dans la direction de la surface de sortie principale.

13. Puce de diode électroluminescente selon l'une quelconque des revendications 1 à 10, dans laquelle il est prévu une seconde couche de connexion électrique et les premières et secondes couches de connexion électrique sont disposées sur des faces mutuellement opposées de la séquence de couches semi-conductrices.

14. Puce de diode électroluminescente selon l'une quelconque des revendications précédentes,
dans laquelle la surface de sortie principale de la séquence de couches semi-conductrices présente une structuration comportant des unités de structure qui présentent une première extension latérale, une seconde extension latérale mesurée perpendiculairement à la première extension latérale et/ou une extension verticale qui est supérieure ou égale à 0,2 fois une longueur d'onde du maximum d'émission du rayonnement électromagnétique et inférieure ou égale à 5 fois une longueur d'onde du maximum d'émission du rayonnement électromagnétique.

15. Puce de diode électroluminescente selon l'une quelconque des revendications précédentes,
dans laquelle un cône de rayonnement émis par la puce de diode électroluminescente présente une distribution de densité de rayonnement qui correspond à une distribution de densité de rayonnement d'un feu de croisement d'un véhicule automobile.
